# EUROPÄISCHE PATENTSCHRIFT

(11) **EP 3 129 522 B1**
(45) Veröffentlichungstag und Bekanntmachung des Hinweises auf die Patenterteilung: **28.02.2018**
(21) Anmeldenummer: 15715705.8
(22) Anmeldetag: 31.03.2015
(51) Int. Cl.: C23C 14/56, C23C 16/54, C23C 16/455, H01J 37/32

(54) **GASVERTEILVORRICHTUNG EINER VAKUUMKAMMER MIT EINER GASFÜHRUNGSEINRICHTUNG**
GAS DISTRIBUTION APPARATUS IN A VACUUM CHAMBER, COMPRISING A GAS CONDUCTING DEVICE
DISPOSITIF DE DISTRIBUTION DE GAZ D'UNE CHAMBRE À VIDE ÉQUIPÉ D'UN MOYEN DE GUIDAGE DE GAZ

(30) Priorität: 09.04.2014 DE 102014105080
(43) Veröffentlichungstag der Anmeldung: 15.02.2017
(73) Patentinhaber: Bühler Alzenau GmbH, 63755 Alzenau (DE)
(72) Erfinder: DUGGEN, Jörg, 63773 Goldbach (DE)
(74) Vertreter: Pohlmann, Bernd Michael
(86) Internationale Anmeldenummer: PCT/EP2015/057115
(87) Internationale Veröffentlichungsnummer: WO 2015/155078

(56) Entgegenhaltungen:
- EP-A2- 0 444 253
- JP-A- S58 197 724
- TW-A- 201 406 979
- US-A1- 2003 186 517
- US-A1- 2007 034 158
- US-A1- 2014 076 714

## Beschreibung

### Stand der Technik

Die Erfindung betrifft eine Gasverteilvorrichtung einer Vakuumkammer mit einer Gasführungseinrichtung, insbesondere einer Vorrichtung zum Aufbringen dünner Schichten auf ein Substrat mittels des Kathodenzerstäubungsverfahrens, nach den Oberbegriffen der unabhängigen Ansprüche.
Aus der EP 0 444 253 B1 ist eine Vorrichtung zum Aufbringen dünner Schichten auf ein Substrat mittels des Kathodenzerstäubungsverfahrens in einer Vakuumkammer bekannt, durch die das zu beschichtende Substrat hindurchbewegbar ist. Zwischen einer zu zerstäubenden Kathode und einer Anode ist eine Blende angeordnet, wobei die Substratebene unterhalb der Anode verläuft. Es sind parallel zur Kathodenebene und im Bereich zwischen der Kathode und der Anode mit Kanälen versehene Hohlprofile vorgesehen, die von der Wand der Vakuumkammer gehalten sind, und die von einem Temperiermedium und von einem Prozessgas durchströmt sind. Dabei weisen die Kanäle für das Prozessgas Öffnungen auf, die quer zur Längsachse dieses Kanals verlaufen und den Austritt von Prozessgas in die Vakuumkammer ermöglichen.

Das Pantentdokument JP S58 197724 A offenbart eine Gasverteilervorrichtung in einer CVD Kammer bestehend aus einem extrudiertem Material. Das Temperiermedium als auch das Prozessgas werden in Kanälen geführt, die von einem einstückig und als Hohlprofil ausgeformten Bauteil gebildet sind, wobei Öffnungen für den Austritt des Gases quer zur Längsachse der Kanäle verlaufen. Die Vorrichtung weist ein Hohlprofil auf, das durch eine rechteckige Querschnittsfläche mit abgerundeten Ecken gekennzeichnet ist. Dieses Profil hat eindeutige und gut zugängliche Kontaktstellen und ermöglicht den Anschluss von Temperiermedium und Prozessgas außerhalb der Vakuumkammer.

### Offenbarung der Erfindung

Die Aufgabe der Erfindung ist es, eine Gasverteilvorrichtung einer Vakuumkammer zu schaffen, die bei einfacher und kostengünstiger Ausführung eine verbesserte und vor allem betriebssichere Verteilung von Gasen in einer Vakuumkammer erlaubt.

Die Aufgaben werden durch die Merkmale des unabhängigen Anspruchs 1 gelöst. Günstige Ausgestaltungen und Vorteile der Erfindung ergeben sich aus den weiteren Ansprüchen, der Beschreibung und der Zeichnung.
Die Erfindung geht nach einem Aspekt der Erfindung aus von einer Gasverteilvorrichtung einer Vakuumkammer mit einer Gasführungseinrichtung, die zumindest einen Gasführungskanal umfasst, der Düsen aufweist, aus denen Gas in die Vakuumkammer verteilt werden kann, und mit einer Gaszufuhreinrichtung, mittels welcher der Gasführungseinrichtung Gas zugeführt werden kann, wobei der zumindest eine Gasführungskanal aus einem einstückig als Hohlprofil ausgebildeten Bauteil gebildet ist. Die Vakuumkammer ist zum Aufbringen von dünnen Schichten auf Substrate ausgebildet und eingerichtet. Es versteht sich, daß von der Erfindung auch Ausführungsformen umfaßt werden, bei denen mehrere als Hohlprofil ausgebildete Bauteile vorgesehen sind.
Es wird vorgeschlagen, dass von dem einstückig als Hohlprofil ausgebildeten Bauteil auch zumindest ein Gaszufuhrkanal (im Stand der Technik auch Gasleitung genannt) der Gaszufuhreinrichtung gebildet ist. Ein solches Hohlprofil kann beispielsweise günstig als Stranggußprofil, beispielsweise aus Aluminium hergestellt werden. Der zumindest eine Gaszufuhrkanal ist daher Bestandteil des Stranggußprofil bzw. das Stranggußprofil umfaßt den zumindest einen Gaszufuhrkanal. Es versteht sich, daß auch mehrere Gaszufuhrkanäle bzw. Gasleitungen Bestandteil des Stranggußprofils sein können.
Die erfindungsgemäße Lösung einer Gasverteilvorrichtung erlaubt so eine Vereinfachung und Verbesserung der Gasverteilvorrichtung insbesondere für die Beschichtung dünner Substrate mittels Kathodenzerstäubungsverfahren in einer Vakuumkammer. Die Gasverteilvorrichtung erlaubt eine Integration von verschiedenen Funktionsteilen, Gasführungskanal und Gaszufuhreinrichtung in ein spezielles Bauteil. Durch die geeignete Wahl des Querschnitts eines Hohlprofils, insbesondere eines Aluminium-Hohlprofils, kann die Gasverteilvorrichtung vereinfacht gefertigt werden. Eine Optimierung einer Gasverteilvorrichtung aus wirtschaftlichen Gründen ist so möglich. Die Anzahl der notwendigen Bauteile kann beträchtlich reduziert werden, kürzere Montagezeiten einer Beschichtungseinrichtung in einer Vakuumkammer sind möglich.
Die erfindungsgemäße Lösung einer Gasverteilvorrichtung vermeidet so die Nachteile, dass beispielsweise die Zu- und Rückführung eines Gasmediums sowie die Versorgung mit Prozessgas jeweils über separate, mehrstückige Rohrleitungen bzw. Gasleitungen erfolgt und somit sehr anfällig für Betriebsstörungen und aufwendig in der Herstellung und Wartung ist. Derartige Rohrleitungen weisen nämlich Biegungen, Wicklungen, Schraubverbindungen und Lötstellen auf, die sich unter Betriebsbedingungen der Vorrichtung im Vakuum befinden, was durch zusätzlichen Einfluss von prozessbedingter Wärme zu Haarrissen und Undichtigkeiten in den Rohrleitungen führen kann. Diese Undichtigkeiten (Lecks) beeinträchtigen zunächst die Schichtqualität, beispielsweise die Haftfähigkeit, der auf das Substrat aufzubringenden Schicht bei einem Kathodenzerstäubungsprozess (Sputtern) oder bei einer chemischen Gasphasenabscheidung (CVD-Verfahren) und können anschließend zwangsläufig zum Total-Ausfall der gesamten Anlage führen, der immer mit erheblichem Aufwand und großen Kosten verbunden ist.

Gemäß eines vorteilhaften weiteren Aspekts der Erfindung kann eine Gasverteilvorrichtung einer Vakuumkammer mit einer Gasführungseinrichtung zumindest einen Hauptkanal mit Hauptkanaldüsen, aus denen ein Hauptgas in die Vakuumkammer verteilt werden kann, sowie zumindest einen Tuningkanal mit Tuningkanaldüsen, aus denen zumindest ein Tuninggas in die Vakuumkammer verteilt werden kann, umfassen. Die Vakuumkammer ist zum Aufbringen von dünnen Schichten auf Substrate ausgebildet und eingerichtet.

Weiter kann die Gasverteilvorrichtung mit einer Gaszufuhreinrichtung mit zumindest einem Hauptgas-Zufuhrkanal (Hauptgas-Gasleitung), mittels dem dem Hauptkanal das Hauptgas und mit zumindest einem Tuninggas-Zufuhrkanal, mittels dem dem Tuningkanal das Tuninggas zugeführt werden kann, ausgebildet sein. Der zumindest eine Hauptkanal kann weiter aus einem einstückig als Hohlprofil ausgebildeten Bauteil gebildet sein. Ein solches Hohlprofil kann beispielsweise günstig als Stranggußprofil, beispielsweise aus Aluminium hergestellt werden. Vorteilhaft kann dabei von dem einstückig als Hohlprofil bzw. Stranggußprofil ausgebildeten Bauteil auch der zumindest eine Hauptgas-Zufuhrkanal und/oder der zumindest eine Tuninggas-Zufuhrkanal gebildet sein. Als sogenanntes Hauptgas kann dabei das wesentliche Prozessgas für den Kathodenzerstäubungsprozess, beispielsweise Argon oder Stickstoff, benutzt werden.

Als sogenannte Tuninggase kommen Gase in Betracht, die zur Bildung von Beschichtungswerkstoffen zur Beschichtung dünner Substrate im Kathodenzerstäubungsprozess wesentlich sind, also beispielsweise bestimmte Elemente für die Bildung chemischer Verbindungen. Auch können weitere Gase, wie beispielsweise zusätzliche Edelgase, die zur Reduzierung der kinetischen Energie von Ionen im Kathodenzerstäubungsplasma, eingesetzt werden können, als Tuninggase in der Gasverteilvorrichtung dem Vakuumbehälter zugeführt werden.

Zweckmäßigerweise kann so von dem einstückig als Hohlprofil, insbesondere als Stranggußprofil ausgebildeten Bauteil auch der zumindest eine Tuningkanal gebildet sein. Auf diese Weise lässt sich eine umfangreiche Gasverteilvorrichtung auf besonders wirtschaftliche Weise durch die hohe Flexibilität in der Fertigung umsetzen. Die Erfindung umfaßt auch den Fall, bei dem zwei Hohlprofile, ein erstes für den Hauptkanal und ein zweites für den Tuningkanal eingesetzt werden.

In einer vorteilhaften Ausgestaltung kann der zumindest eine Tuningkanal mehrere entlang einer Kanallängserstreckung hintereinander angeordnete kammerartige Segmente umfassen. Eine solche Anordnung bietet den Vorteil, dass die Tuninggase in verschiedenen Bereichen der Vakuumkammer gezielt eingelassen werden können, um so bei der Beschichtung eines Substrats an unterschiedlichen Stellen ganz unterschiedliche Beschichtungsverhältnisse zu realisieren. So können an unterschiedlichen Stellen unterschiedliche Beschichtungsparameter oder gar unterschiedliche Werkstoffe eingesetzt werden. Auch können unterschiedliche Schichtdicken oder auch unterschiedliche Schichteigenschaften auf günstige Weise erreicht werden. Je nach Anforderungen an die Schichtverteilung kann die Gasverteilvorrichtung auch für eine größere Zahl an Segmenten ausgeführt sein.

Zweckmäßigerweise können zumindest zwei aufeinanderfolgende Segmente eine gemeinsame Quer-Trennwand aufweisen. Die Herstellung solcher Segmente eines Tuningkanals, der aus einem Hohlprofil gefertigt wird, kann durch Fräsen eines Schlitzes in einer Querrichtung zu dem Hohlprofil und Einfügen (Einpressen) und Fixieren bzw. durch Schweißen eines Trennelementes, beispielsweise einer Segmentplatte, vorzugsweise aus Aluminium erfolgen. Bei einen Stranggußprofil wird also entsprechend das Stranggußprofil geschlitzt. Auf diese Weise können zwei Segmente mit einer gemeinsamen Quer-Trennwand gebildet werden.

Der Vorteil von getrennten Segmenten besteht darin, dass jedem Segment über mindestens einen Tuninggas-Zufuhrkanal Tuninggas getrennt zugeführt werden kann. So können als Tuninggase unterschiedliche Gassorten verwendet werden, die zu unterschiedlichen chemischen Verbindungen in einem Kathodenzerstäubungsverfahren genutzt werden können. Diese getrennte Gasdosierung für jedes Segment ermöglicht eine sehr flexible Ausgestaltung eines Beschichtungsprozesses für komplexe Bauteile mit unterschiedlichen Beschichtungsanforderungen in der großflächigen Ausgestaltung der Bauteile oder auch beispielsweise in einer Aufeinanderfolge unterschiedlicher Schichten im Gesamtaufbau der Beschichtung.

Günstigerweise können Hauptkanal und Tuningkanal eine gemeinsame Längs-Trennwand aufweisen. Eine solche Ausgestaltung ermöglicht eine sehr effektive und damit kostengünstige Fertigung eines solchen Bauteils, das dadurch mehrere Funktionen in einem solchen Bauteil integrieren und nutzen kann. Auch als mechanische Integrationslösung für eine vereinfachte Montage der Gasverteilvorrichtung in einer Beschichtungsanlage ist eine solche Ausführung in einem Bauteil sehr zweckmäßig. Es versteht sich, dass Hauptkanal und Tuningkanal auch ein getrennte Längs-Trennwände, also eine beispielsweise eine Doppelwand aufweisen können.

Gemäß einer vorteilhaften Ausgestaltung kann der zumindest eine Hauptgas-Zufuhrkanal an einem Außenbereich einer Hauptkanalwandung angeordnet sein. Dadurch ist es möglich, den Hauptgas-Zufuhrkanal in das Hohlprofil, das den Hauptkanal und eventuell Tuningkanäle umfassen kann, effektiv zu integrieren und als ein Bauteil zu fertigen. Auch eine mechanisch stabile Verbindung zu dem Hauptkanal ist auf diese Weise von selbst gegeben, was wiederum für eine effektive Montage der Gasverteilvorrichtung von großem Vorteil ist.

Ebenso zweckmäßig kann der zumindest eine Tuninggas-Zufuhrkanal an einem Außenbereich der Tuningkanalwandung angeordnet sein. Auch hier gilt der gleiche Vorteil einer mechanisch stabilen und zugleich montagefreundlichen Anordnung von Tuninggas-Zufuhrkanal und Tuningkanal in einem integralen Bauteil, das als Hohlprofil günstig realisiert werden kann.

In einer vorteilhaften Ausgestaltung kann der zumindest eine Hauptgas-Zufuhrkanal über zumindest eine Zufuhröffnung in der Hauptkanalwandung mit dem Hauptkanal verbunden sein. Auf diese Weise ist es möglich, eine sehr einfache und robuste Verbindung zu schaffen, welche den Anforderungen an mechanische Stabilität und dauerhafter Abdichtung standhält.

So ist es beispielsweise möglich, die Zufuhröffnung als durch den Hauptkanal-Zufuhrkanal bis in den Innenbereich des Hauptkanals geführte Querbohrung auszubilden, die in einem nicht zum Hauptkanal führenden Bereich in der Wandung des Hauptgas-Zufuhrkanals verschlossen ist. Eine solche Ausbildung erlaubt eine sehr einfache und kostengünstige Fertigung der Verbindung zwischen Hauptkanal-Zufuhrkanal und Hauptkanal, indem eine Querbohrung senkrecht zu dem Hohlprofil ausgeführt wird, welche den Hauptkanal-Zufuhrkanal mit dem Hauptkanal verbindet und anschließend die Bohrung in der Hauptkanalwandung zum Außenbereich wieder verschließt.

Ebenso ist es auch günstig, wenn der zumindest eine Tuninggas-Zufuhrkanal über zumindest eine Zufuhröffnung in der Tuningkanalwandung mit dem Tuningkanal verbunden ist. Auf diese Weise ist es möglich, eine sehr einfache und robuste Verbindung zu schaffen, welche den Anforderungen an mechanische Stabilität und dauerhafter Abdichtung standhält.

Wie bei dem Hauptkanal-Zufuhrkanal kann dabei die Zufuhröffnung als durch den Tuninggas-Zufuhrkanal bis in den Innenbereich des Tuningkanals geführte Querbohrung ausgebildet sein, die in einem nicht zum Tuningkanal führenden Bereich in der Wandung des Tuninggas-Zufuhrkanals verschlossen ist. Eine solche Ausbildung erlaubt eine sehr einfache und kostengünstige Fertigung der Verbindung zwischen Tuningkanal-Zufuhrkanal und Tuningkanal, indem eine Querbohrung senkrecht zu dem Hohlprofil ausgeführt wird, welche den Tuningkanal-Zufuhrkanal mit dem Tuningkanal verbindet und anschließend die Bohrung in der Tuningkanalwandung zum Außenbereich wieder verschließt.

Vorteilhaft ist es, wenn der Innenbereich des Hauptkanals und/oder der Innenbereich des Tuningkanals einen rechteckigen Querschnitt aufweist. Eine solche Ausgestaltung erlaubt die Verbindung von günstigen Herstellverfahren mit großer mechanischer Stabilität und Montagefreundlichkeit, da sich rechteckige Querschnitte günstig an ebenen Flächen anbringen und raumsparend montieren lassen. Es versteht sich, dass der Innenbereich des Hauptkanals und/oder der Innenbereich des Tuningkanals auch andere Querschnittsformen, beispielsweise kreisförmige oder ovale Querschnitte aufweisen können.

Gemäß einer vorteilhaften Ausgestaltung kann die Gasführungseinrichtung einen dem Innenbereich der Vakuumkammer zugeordneten Bereich und einen der Kammerwand der Vakuumkammer zugeordneten Bereich aufweisen, und zumindest ein erster Tuninggas-Zufuhrkanal in dem dem Innenbereich der Vakuumkammer zugeordneten Bereich angeordnet und ein zweiter Tuninggas-Kanal in dem der Kammerwand der Vakuumkammer zugeordneten Bereich angeordnet sein. Auf diese Weise lassen sich möglichst viele Tuninggas-Zufuhrkanäle an einem Tuningkanal unterbringen. Weiter kann es zweckmäßig sein, einen Tuninggas-Zufuhrkanal direkt im Innenbereich der Vakuumkammer zur Verfügung zu haben, um so auch beispielsweise direkt von dem Tuninggas-Zufuhrkanal Tuninggas in die Vakuumkammer einzubringen. Auch mag es vorteilhaft sein, zur Temperierung von Tuninggasen diese Tuninggas-Zufuhrkanäle an einem einer Außenwandung der Vakuumkammer verbunden Bereich unterzubringen, sodass über die Wandung eine Temperierung des Tuninggases erfolgen kann.

### Zeichnungen

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

### Es zeigen beispielhaft:

- Fig. 1: einen Querschnitt durch eine Gasverteilvorrichtung mit einem Hauptkanal und einem Tuningkanal nach einem Ausführungsbeispiel der Erfindung, die in einem Ausschnitt einer Vakuumkammer angeordnet ist; und
- Fig. 2: eine isometrische Ansicht einer Gasverteilvorrichtung nach einem Ausführungsbeispiel der Erfindung aus zwei Hohlprofilen, deren Zufuhrkanäle über Zuleitungen verbunden sind.

### Ausführungsform der Erfindung

In den Figuren sind gleiche oder gleichartige Komponenten mit gleichen Bezugszeichen beziffert. Die Figuren zeigen lediglich Beispiele und sind nicht beschränkend zu verstehen.

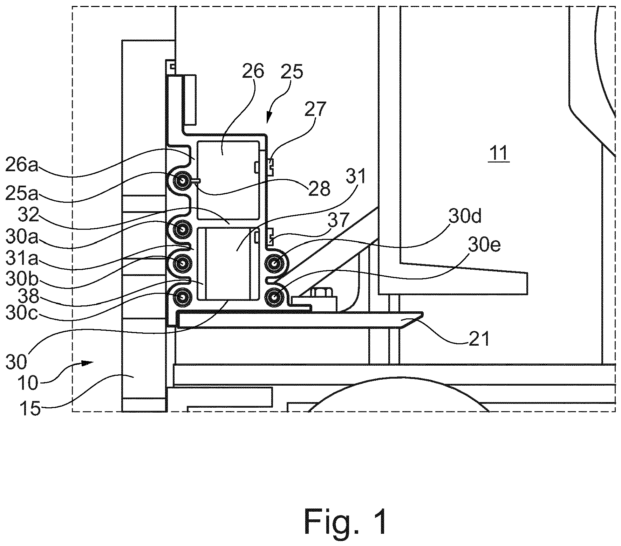

Figur 1 zeigt einen Querschnitt durch eine Gasverteilvorrichtung mit einem Hauptkanal und einem Tuningkanal nach einem Ausführungsbeispiel der Erfindung, die in einem Ausschnitt einer Vakuumkammer 10 angeordnet ist. Die Gasverteilvorrichtung einer Vakuumkammer 10 mit einer Gasführungseinrichtung umfasst als Gasführungskanäle einen Hauptkanal 25 mit Hauptkanaldüsen 27, aus denen ein Hauptgas in die Vakuumkammer 10 verteilt werden kann, sowie einen Tuningkanal 30 mit Tuningkanaldüsen 37, 37', aus denen zumindest ein Tuninggas in die Vakuumkammer 10 verteilt werden kann. Weiter umfasst die Gasverteilvorrichtung eine Gaszufuhreinrichtung mit einem Hauptgas-Zufuhrkanal 25a, mittels dem dem Hauptkanal 25 das Hauptgas und mit den Tuninggas-Zufuhrkanälen 30a, 30b, 30c, 30d, 30e, mittels denen dem Tuningkanal 30 das Tuninggas zugeführt werden kann. Der Hauptkanal 25 ist aus einem einstückig als Hohlprofil ausgebildeten Bauteil 20 gebildet, wobei von dem einstückig als Hohlprofil ausgebildeten Bauteil 20 auch der Hauptgas-Zufuhrkanal 25a und die Tuninggas-Zufuhrkanäle 30a, 30b, 30c, 30d, 30e gebildet sind. Das Bauteil 20 ist als Stranggußprofil ausgebildet. Von dem als Hohlprofil ausgebildeten Bauteil 20 ist auch der eine Tuningkanal 30 gebildet. Da der Hauptkanal 25 und Tuningkanal 30 direkt übereinander angeordnet sind, weisen sie eine gemeinsame Längs-Trennwand 32 auf. Der Hauptgas-Zufuhrkanal 25a ist an einem Außenbereich einer Hauptkanalwandung 26a angeordnet und liegt an der Kammerwand 15 der Vakuumkammer 10 an. Die Tuninggas-Zufuhrkanäle 30a, 30b, 30c sind ebenfalls an dem Außenbereich der Tuningkanalwandung 31a angeordnet und liegen ebenfalls an der Kammerwand 15 an. In einer weiteren Ausführungsform liegen der Hauptgas-Zufuhrkanal und/oder die die Tuninggas-Zufuhrkanäle nicht an der Kammerwand an.
Der Innenbereich 26 des Hauptkanals 25 und der Innenbereich 31 des Tuningkanals 30 weisen einen rechteckigen Querschnitt auf. Die Gaszuführungsvorrichtung weist einen dem Innenbereich 11 der Vakuumkammer 10 zugeordneten Bereich und einen der Kammerwand 15 der Vakuumkammer 10 zugeordneten Bereich auf. Dabei sind die Tuninggas-Zufuhrkanäle 30d, 30e in dem dem Innenbereich 11 der Vakuumkammer 10 zugeordneten Bereich angeordnet und die Tuninggas-Zufuhrkanäle 30a, 30b, 30c in dem der Kammerwand 15 der Vakuumkammer 10 zugeordneten Bereich angeordnet.
Der Hauptgas-Zufuhrkanal 25a ist über zumindest eine Zufuhröffnung 28 oder über mehrere Zufuhröffnungen 28 in der Hauptkanalwandung 26a mit dem Hauptkanal 25 verbunden, wobei die Zufuhröffnung 28 als durch den Hauptkanal-Zufuhrkanal 25a bis in den Innenbereich 26 des Hauptkanals geführte Querbohrung ausgebildet ist, die in einem nicht zum Hauptkanal 25 führenden Bereich in der Wandung des Hauptgas-Zufuhrkanals 25a verschlossen ist. Die Tuninggas-Zufuhrkanäle 30a, 30b, 30c, 30d, 30e sind ebenfalls über zumindest eine Zufuhröffnung 38, oder auch mehrere Zufuhröffnungen 38, in der Tuningkanalwandung 31a mit dem Tuningkanal 30 verbunden, wobei die Zufuhröffnung 38 als durch die Tuninggas-Zufuhrkanäle 30a, 30b, 30c, 30d, 30e bis in den Innenbereich 26 des Tuningkanals 30 geführte Querbohrung ausgebildet sind, die in einem nicht zum Tuningkanal 30 führenden Bereich in der Wandung der Tuninggas-Zufuhrkanäle 30a, 30b, 30c, 30d, 30e verschlossen sind. In Figur 1 ist in der Zeichnungsebene eine Zufuhröffnung 38 des Tuninggas-Zufuhrkanals 30b dargestellt. Die Zufuhröffnungen der übrigen Tuninggas-Zufuhrkanäle 30a, 30c, 30d, 30e liegen in anderen Zeichnungsebenen der Darstellung der Gasverteilvorrichtung.
Senkrecht zur Kammerwand 15 und anliegend an die untere Seite des Tuningkanals 30 ist ein Leitblech 21 angeordnet, welches eine günstige Strömung der Gase beim Ausströmen von dem Hauptkanal 25 sowie dem Tuningkanal 30 in die Vakuumkammer 10 bewirken kann. In der Zeichenebene von Figur 1 ist eine Hauptkanaldüse 27 in einer Wandung des Hauptkanals 25 zum Innenbereich 11 der Vakuumkammer 10 dargestellt, über welche das Hauptgas in die Vakuumkammer 10 strömen kann, sowie eine Tuningkanaldüse 37, über welche das Tuninggas in die Vakuumkammer 10 strömen kann. Weitere Hauptkanaldüsen 27, über welche das Hauptgas, sowie Tuningkanaldüsen 37, über welche das Tuninggas in die Vakuumkammer 10 strömen kann, liegen in anderen Ebenen.

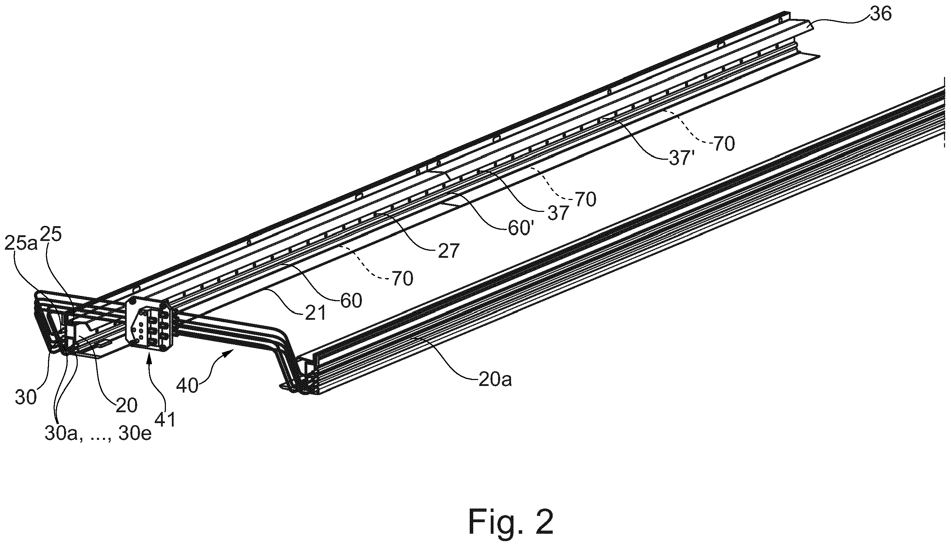

In Figur 2 ist eine isometrische Ansicht einer Gasverteilvorrichtung nach einem Ausführungsbeispiel der Erfindung aus zwei einstückigen Bauteilen 20, 20a in Form von Hohlprofilen, deren Gaszufuhrkanäle 25a, 30a, 30b, 30c, 30d, 30e über Zuleitungen 40 verbunden sind. Die Zuleitungen 40 werden über eine Vakuumdurchführung 41 in eine Vakuumkammer 10 (nicht dargestellt) durchgeführt und speisen beide Hauptkanäle 25 und Tuningkanäle 30 der beiden Bauteile 20, 20a der Gasverteilvorrichtung parallel. Ein Tuningkanal 30 der Gasverteilvorrichtung umfasst mehrere hintereinander angeordnete kammerartige Segmente 60, 60', wobei zwei aufeinanderfolgende Segmente 60, 60' eine gemeinsame Quer-Trennwand 70 bzw. eine Segmentplatte aufweisen.

Der Vorteil der Unterteilung des Tuningkanals 30 in die einzelnen Segmente 60, 60' liegt darin, dass jedem Segment 60, 60' über mindestens einen Tuninggas-Zufuhrkanal 30a, 30b, 30c, 30d, 30e Tuninggas getrennt zugeführt werden kann. Eine solche Anordnung bietet den Vorteil, dass die Tuninggase in verschiedenen Bereichen der Vakuumkammer 10 gezielt eingelassen werden können, um so bei der Beschichtung eines Substrats an unterschiedlichen Stellen ganz unterschiedliche Beschichtungsverhältnisse zu realisieren. So können an unterschiedlichen Stellen unterschiedliche Beschichtungsparameter oder gar unterschiedliche Werkstoffe eingesetzt werden. Auch können unterschiedliche Schichtdicken oder auch unterschiedliche Schichteigenschaften auf günstige Weise erreicht werden. Je nach Anforderungen an die Schichtverteilung kann die Gasverteilvorrichtung auch für eine größere Zahl an Segmenten ausgeführt sein. So können als Tuninggase unterschiedliche Gassorten verwendet werden, die zu unterschiedlichen chemischen Verbindungen in einem Kathodenzerstäubungsverfahren genutzt werden können. Diese getrennte Gasdosierung für jedes Segment 60, 60' ermöglicht eine sehr flexible Ausgestaltung eines Beschichtungsprozesses für komplexe Bauteile mit unterschiedlichen Beschichtungsanforderungen in der großflächigen Ausgestaltung der Bauteile oder auch beispielsweise in einer Aufeinanderfolge unterschiedlicher Schichten im Gesamtaufbau der Beschichtung.

Die Gasführung in der Vakuumkammer kann dabei durch die Leitbleche 21 und 36 in geeigneter Weise gestaltet werden. Das Hauptgas kann aus dem Hauptkanal 25 über die Hauptkanaldüsen 27, das Tuninggas aus dem Tuningkanal 30 über die Tuningkanaldüsen 37 in die Vakuumkammer 10 strömen und über die Leitbleche 21 und 36 auch im Vakuum geeignet geleitet werden.

### Bezugszeichenliste

- 10: Vakuumkammer
- 11: Innenbereich der Vakuumkammer
- 15: Kammerwand
- 20: Bauteil
- 20a: Bauteil
- 21: Leitblech
- 25: Hauptkanal
- 25a: Hauptgas-Zufuhrkanal
- 26: Innenbereich des Hauptkanals
- 26a: Hauptkanalwandung
- 27: Düse
- 28: Zufuhröffnung
- 30: Tuningkanal
- 30a: Tuninggas-Zufuhrkanal
- 30b: Tuninggas-Zufuhrkanal
- 30c: Tuninggas-Zufuhrkanal
- 30d: Tuninggas-Zufuhrkanal
- 30e: Tuninggas-Zufuhrkanal
- 31: Innenbereich des Tuningkanals
- 31a: Tuningkanalwandung
- 32: Längs-Trennwand
- 36: Leitblech
- 37: Düse
- 37': Düse
- 38: Zufuhröffnung
- 40: Zuleitungen
- 41: Vakuumdurchführung
- 60: Segment
- 60': Segment
- 70: Quer-Trennwand, Segmentplatte

## Patentansprüche

1. Gasverteilrrorrichtung einer Vakuumkammer (10) mit einer Gasführungseinrichtung, die zumindest einen Hauptkanal (25) umfasst, der Düsen (27) aufweist, aus denen Gas in die Vakuumkammer (10) verteilt werden kann, und mit einer Gaszufuhreinrichtung, mittels welcher der Gasführungseinrichtung Gas zugeführt werden kann, wobei der zumindest eine Hauptkanal (25) aus einem einstückig als Hohlprofil ausgebildeten Bauteil (20) gebildet ist und von dem einstückig als Hohlprofil ausgebildeten Bauteil (20) auch zumindest ein Hauptgas-Zufuhrkanal (25a) der Gaszufuhreinrichtung und zumindest ein Tuningkanal (30) mit Tuningkanaldüsen (37, 37'), aus denen zumindest ein Tuninggas in die Vakuumkammer (10) verteilt werden kann, gebildet ist, **dadurch gekennzeichnet, dass** das Bauteil (20) als Stranggußprofil ausgebildet ist.

2. Gasverteilvorrichtung einer Vakuumkammer (10) mit einer Gasführungseinrichtung nach Anspruch 1, **dadurch gekennzeichnet, dass**
von dem einstückig als Hohlprofil ausgebildeten Bauteil (20) auch zumindest ein Tuninggas-Zufuhrkanal (30a, ..., 30e) gebildet ist.

3. Gasverteilvorrichtung nach Anspruch 1 oder 2, **dadurch gekennzeichnet, dass** der zumindest eine Tuningkanal (30) mehrere entlang einer Kanallängserstreckung hintereinander angeordnete kammerartige Segmente (60, 60') umfasst.

4. Gasverteilvorrichtung nach Anspruch 3, **dadurch gekennzeichnet, dass** zumindest zwei aufeinanderfolgende Segmente (60, 60') eine gemeinsame Quer-Trennwand (70) aufweisen.

5. Gasverteilvorrichtung nach Anspruch 3 oder 4, **dadurch gekennzeichnet, dass** jedem Segment (60, 60') über mindestens einen Tuninggas-Zufuhrkanal (30a, ..., 30e) Tuninggas getrennt zugeführt wird oder zuführbar ist.

6. Gasverteilvorrichtung nach zumindest einem der Ansprüche 2 bis 5, **dadurch gekennzeichnet, dass** Hauptkanal (25) und Tuningkanal (30) eine gemeinsame Längs-Trennwand (32) aufweisen.

7. Gasverteilvorrichtung nach zumindest einem der Ansprüche 2 bis 6, **dadurch gekennzeichnet, dass** der zumindest eine Hauptgas-Zufuhrkanal (25a) an einem Außenbereich einer Hauptkanalwandung (26a) angeordnet ist.

8. Gasverteilvorrichtung nach einem der Ansprüche 2 bis 7, **dadurch gekennzeichnet, dass** der zumindest eine Tuninggas-Zufuhrkanal (30a, ..., 30e) an einem Außenbereich der Tuningkanalwandung (31a) angeordnet ist.

9. Gasverteilvorrichtung nach einem der Ansprüche 7 oder 8, **dadurch gekennzeichnet, dass** der zumindest eine Hauptgas-Zufuhrkanal (25a) über zumindest eine Zufuhröffnung (28) in der Hauptkanalwandung (26a) mit dem Hauptkanal (25) verbunden ist.

10. Gasverteilvorrichtung nach Anspruch 9, **dadurch gekennzeichnet, dass** die Zufuhröffnung (28) als durch den Hauptkanal-Zufuhrkanal (25a) bis in den Innenbereich (26) des Hauptkanals geführte Querbohrung ausgebildet ist, die in einem nicht zum Hauptkanal (25) führenden Bereich in der Wandung des Hauptgas-Zufuhrkanals (25a) verschlossen ist.

11. Gasverteilvorrichtung nach einem der Ansprüche 8 bis 10, **dadurch gekennzeichnet, dass** der zumindest eine Tuninggas-Zufuhrkanal (30a, ..., 30e) über zumindest eine Zufuhröffnung (38) in der Tuningkanalwandung (31a) mit dem Tuningkanal (30) verbunden ist.

12. Gasverteilvorrichtung nach Anspruch 11, **dadurch gekennzeichnet, dass** die Zufuhröffnung (38) als durch den Tuninggas-Zufuhrkanal (30a, ..., 30e) bis in den Innenbereich (26) des Tuningkanals (30) geführte Querbohrung ausgebildet ist, die in einem nicht zum Tuningkanal (30) führenden Bereich in der Wandung des Tuninggas-Zufuhrkanals (30a, ... 30e) verschlossen ist.

13. Gasverteilvorrichtung nach einem der Ansprüche 2 bis 12, **dadurch gekennzeichnet, dass** der Innenbereich (26) des Hauptkanals (25) und/oder der Innenbereich (31) des Tuningkanals (30) einen rechteckigen Querschnitt aufweisen.

14. Gasverteilvorrichtung nach einem der Ansprüche 2 bis 13, **dadurch gekennzeichnet, dass** die Gasführungseinrichtung einen dem Innenbereich (11) der Vakuumkammer (10) zugeordneten Bereich und einen der Kammerwand (15) der Vakuumkammer (10) zugeordneten Bereich aufweist, und dass zumindest ein erster Tuninggas-Zufuhrkanal (30a, ..., 30e) in dem dem Innenbereich (11) der Vakuumkammer (10) zugeordneten Bereich angeordnet und ein zweiter Tuninggas-Zufuhrkanal (30a, ..., 30e) in dem der Kammerwand (15) der Vakuumkammer (10) zugeordneten Bereich angeordnet ist.

## Claims

1. Gas distribution apparatus of a vacuum chamber (10) with a gas conducting device, which comprises at least one main duct (25) that has nozzles (27), from which gas can be distributed into the vacuum chamber (10), and with a gas supplying device, by means of which gas can be supplied to the gas conducting device, the at least one main duct (25) being formed by a component (20) formed in one piece as a hollow profile, and at least one main gas supply duct (25a) of the gas supplying device and at least one tuning duct (30) with tuning duct nozzles (37, 37'), from which at least one tuning gas can be distributed into the vacuum chamber (10), also being formed by the component (20) formed in one piece as a hollow profile, **characterized in that** the component (20) is formed as an extruded section.

2. Gas distribution apparatus of a vacuum chamber (10) with a gas conducting device according to Claim 1, **characterized in that** at least one tuning gas supply duct (30a, ..., 30e) is also formed by the component (20) formed in one piece as a hollow profile.

3. Gas distribution apparatus according to Claim 1 or 2, **characterized in that** the at least one tuning duct (30) comprises multiple chamber-like segments (60, 60') arranged one after the other along a longitudinal extent of the duct.

4. Gas distribution apparatus according to Claim 3, **characterized in that** at least two successive segments (60, 60') have a common transverse partition wall (70).

5. Gas distribution apparatus according to Claim 3 or 4, **characterized in that** tuning gas is or can be supplied separately to each segment (60, 60') via at least one tuning gas supply duct (30a, ..., 30e).

6. Gas distribution apparatus according to at least one of Claims 2 to 5, **characterized in that** the main duct (25) and the tuning duct (30) have a common longitudinal partition wall (32).

7. Gas distribution apparatus according to at least one of Claims 2 to 6, **characterized in that** the at least one main gas supply duct (25a) is disposed on an outer region of a main duct wall (26a).

8. Gas distribution apparatus according to one of Claims 2 to 7, **characterized in that** the at least one tuning gas supply duct (30a, ..., 30e) is disposed on an outer region of the tuning duct wall (31a).

9. Gas distribution apparatus according to either of Claims 7 and 8, **characterized in that** the at least one main gas supply duct (25a) is connected to the main duct (25) via at least one feed opening (28) in the main duct wall (26a).

10. Gas distribution apparatus according to Claim 9, **characterized in that** the feed opening (28) is formed as a cross hole taken through the main duct supply duct (25a) into the inner region (26) of the main duct, which cross hole is closed in a region in the wall of the main gas supply duct (25a) that does not lead to the main duct (25).

11. Gas distribution apparatus according to one of Claims 8 to 10, **characterized in that** the at least one tuning gas supply duct (30a, ..., 30e) is connected to the tuning duct (30) via at least one feed opening (38) in the tuning duct wall (31a).

12. Gas distribution apparatus according to Claim 11, **characterized in that** the feed opening (38) is formed as a cross hole taken through the tuning gas supply duct (30a, ..., 30e) into the inner region (26) of the tuning duct (30), which cross hole is closed in a region in the wall of the tuning gas supply duct (30a, ..., 30e) that does not lead to the tuning duct (30).

13. Gas distribution apparatus according to one of Claims 2 to 12, **characterized in that** the inner region (26) of the main duct (25) and/or the inner region (31) of the tuning duct (30) have/has a rectangular cross section.

14. Gas distribution apparatus according to one of Claims 2 to 13, **characterized in that** the gas conducting device has a region assigned to the inner region (11) of the vacuum chamber (10) and a region assigned to the chamber wall (15) of the vacuum chamber (10), and **in that** at least one first tuning gas supply duct (30a, ..., 30e) is disposed in the region assigned to the inner region (11) of the vacuum chamber (10) and a second tuning gas supply duct (30a, ..., 30e) is disposed in the region assigned to the chamber wall (15) of the vacuum chamber (10).

## Revendications

1. Dispositif de distribution de gaz d'une chambre à vide (10) équipé d'un moyen de guidage de gaz qui comporte au moins un canal principal (25), lequel possède des buses (27) depuis lesquelles du gaz peut être distribué dans la chambre à vide (10), et comprenant un moyen d'acheminement de gaz au moyen duquel du gaz peut être acheminé au moyen de guidage de gaz, l'au moins un canal principal (25) étant formé d'un élément structural (20) monobloc réalisé sous la forme d'un profilé creux et au moins un canal d'acheminement de gaz principal (25a) du moyen de guidage de gaz et au moins un canal d'accord (30) pourvu de buses de canal d'accord (37, 37'), depuis lesquelles au moins un gaz d'accord peut être distribué dans la chambre à vide (10), est également formé par l'élément structural (20) monobloc réalisé sous la forme d'un profilé creux, **caractérisé en ce que** l'élément structural (20) est réalisé sous la forme d'un profilé en coulée continue.

2. Dispositif de distribution de gaz d'une chambre à vide (10) comprenant un moyen de guidage de gaz selon la revendication 1, **caractérisé en ce qu'**au moins un canal d'acheminement de gaz d'accord (30a, ..., 30e) est également formé par l'élément structural (20) monobloc réalisé sous la forme d'un profilé creux.

3. Dispositif de distribution de gaz selon la revendication 1 ou 2, **caractérisé en ce que** l'au moins une canal d'accord (30) comporte plusieurs segments (60, 60') disposés les uns derrière les autres à la marnière d'une chambre le long d'une extension en longueur du canal.

4. Dispositif de distribution de gaz selon la revendication 3, **caractérisé en ce qu'**au moins deux segments (60, 60') successifs possèdent une paroi de séparation transversale (70) commune.

5. Dispositif de distribution de gaz selon la revendication 3 ou 4, **caractérisé en ce que** du gaz d'accord est acheminé ou peut être acheminé séparément à chaque segment (60, 60') par le biais d'au moins un canal d'acheminement de gaz d'accord (30a, ..., 30e).

6. Dispositif de distribution de gaz selon au moins l'une des revendications 2 à 5, **caractérisé en ce que** le canal principal (25) et le canal d'accord (30) possèdent une paroi de séparation longitudinale (32) commune.

7. Dispositif de distribution de gaz selon au moins l'une des revendications 2 à 6, **caractérisé en ce que** l'au moins un canal d'acheminement de gaz principal (25a) est disposé au niveau d'une zone extérieure d'une paroi de canal principal (26a).

8. Dispositif de distribution de gaz selon l'une des revendications 2 à 7, **caractérisé en ce que** l'au moins un canal d'acheminement de gaz d'accord (30a, ..., 30e) est disposé au niveau d'une zone extérieure de la paroi de canal d'accord (31a).

9. Dispositif de distribution de gaz selon l'une des revendications 7 ou 8, **caractérisé en ce que** l'au moins un canal d'acheminement de gaz principal (25a) est relié au canal principal (25) par le biais d'au moins une ouverture d'acheminement (28) dans la paroi de canal principal (26a).

10. Dispositif de distribution de gaz selon la revendication 9, **caractérisé en ce que** l'ouverture d'acheminement (28) est réalisée sous la forme d'un perçage transversal passant à travers le canal d'acheminement de canal principal (25a) jusque dans la zone intérieure (26) du canal principal, perçage transversal qui est fermé dans une zone dans la paroi du canal d'acheminement de gaz principal (25a) qui ne mène pas au canal principal (25).

11. Dispositif de distribution de gaz selon l'une des revendications 8 à 10, **caractérisé en ce que** l'au moins un canal d'acheminement de gaz d'accord (30a, ..., 30e) est relié au canal d'accord (30) par le biais d'au moins une ouverture d'acheminement (38) dans la paroi de canal d'accord (31a).

12. Dispositif de distribution de gaz selon la revendication 11, **caractérisé en ce que** l'ouverture d'acheminement (38) est réalisés sous à forme d'un perçage transversal passant à travers le canal d'acheminement de gaz d'accord (30a, ..., 30e) jusque dans la zone intérieure (26) du canal d'accord (30), perçage transversal qui est fermé dans une zone dans la paroi du canal d'acheminement de gaz d'accord (30a, ..., 30e) qui ne mène pas au canal d'accord (30).

13. Dispositif de distribution de gaz selon l'une des revendications 2 à 12, **caractérisé en ce que** la zone intérieure (26) du canal principal (25) et/ou la zone intérieure (31) du canal d'accord (30) possèdent une section transversale parallélépipédique.

14. Dispositif de distribution de gaz selon l'une des revendications 2 à 13, **caractérisé en ce que** le moyen de guidage de gaz possède une zone associée à la zone intérieure (11) de la chambre à vide (10) et une zone associée à la paroi de chambre (15) de la chambre à vide (10), et **en ce qu'**au moins un premier canal d'acheminement de gaz d'accord (30a, ..., 30e) est disposé dans la zone associée à la zone intérieure (11) de la chambre à vide (10) et un deuxième canal d'acheminement de gaz d'accord (30a, ..., 30e) est disposé dans la zone associée à la paroi de chambre (15) de la chambre à vide (10).
